# FASCICULE DE BREVET EUROPEEN

(11) **EP 3 096 456 B1**
(45) Date de publication et mention de la délivrance du brevet: **29.07.2020**
(21) Numéro de dépôt: 15193791.9
(22) Date de dépôt: 10.11.2015
(51) Int. Cl.: H03K 17/725, H01L 29/747, H01L 29/744

(54) **COMMUTATEUR BIDIRECTIONNEL DE PUISSANCE A PERFORMANCES EN COMMUTATION AMELIOREES**
BIDIREKTIONALER LEISTUNGSUMSCHALTER MIT VERBESSERTEN UMSCHALTLEISTUNGEN
BIDIRECTIONAL POWER SWITCH WITH IMPROVED SWITCHING PERFORMANCE

(30) Priorité: 20.05.2015 FR 1554494
(43) Date de publication de la demande: 23.11.2016
(73) Titulaire: STMicroelectronics (Tours) SAS, 37100 Tours (FR)
(72) Inventeur: HAGUE, Yannick, 37390 METTRAY (FR); MENARD, Samuel, 37000 TOURS (FR)
(74) Mandataire: Cabinet Beaumont

(56) Documents cités:
- EP-A1- 0 793 344
- EP-A1- 0 872 891
- EP-A1- 1 061 650
- EP-A2- 0 341 730
- DE-A1- 2 624 044
- JP-A- S58 134 471

## Description

### Domaine

La présente demande concerne un commutateur bidirectionnel de puissance.

### Exposé de l'art antérieur

De nombreux types de commutateurs bidirectionnels de puissance ont déjà été proposés. De tels commutateurs sont par exemple utilisés connectés en série avec une charge à alimenter entre des bornes de fourniture d'une tension alternative d'alimentation (par exemple la tension secteur), pour contrôler la puissance fournie à la charge.

Des exemples de commutateurs bidirectionnels de puissance sont par exemple décrits dans les documents EP0793344, EP0341730, EP0872891, JPS58134471 et EP1061650.

Il existe un besoin pour un commutateur bidirectionnel de puissance palliant tout ou partie des inconvénients des commutateurs connus.

### Résumé

Ainsi, un mode de réalisation prévoit un commutateur bidirectionnel de puissance selon la revendication 1 comportant des premier et second thyristors connectés en antiparallèle entre des première et deuxième bornes de conduction du commutateur, le premier thyristor étant un thyristor à gâchette d'anode, le second thyristor étant un thyristor à gâchette de cathode, et les gâchettes des premier et second thyristors étant reliées à une même borne de commande du commutateur.

Selon un mode de réalisation, le premier dipôle est une diode dont l'anode est connectée à la gâchette du premier thyristor et dont la cathode est connectée à la borne de commande, et le deuxième dipôle est une diode dont l'anode est connectée à la gâchette du deuxième thyristor et dont la cathode est connectée à la borne de commande.

Selon un mode de réalisation, les premier et second thyristors sont de type à amorçage dans le quadrant Q2.

Selon un mode de réalisation, le premier dipôle est une diode dont la cathode est connectée à la gâchette du premier thyristor et dont l'anode est connectée à la borne de commande, et le deuxième dipôle est une diode dont la cathode est connectée à la gâchette du deuxième thyristor et dont l'anode est connectée à la borne de commande.

Selon un mode de réalisation, les premier et second thyristors sont de type à amorçage dans le quadrant Q1.

Selon un mode de réalisation, au moins l'un des premier et deuxième dipôles comprend une résistance de valeur comprise entre 10 et 200 ohms.

Selon un mode de réalisation, les premier et deuxième thyristors sont disposés dans un même boîtier de protection comportant quatre bornes de connexion extérieures connectées respectivement aux première et deuxième bornes de conduction du commutateur, à la gâchette d'anode du premier thyristor, et à la gâchette de cathode du deuxième thyristor, et les premier et deuxième dipôles sont disposés à l'extérieur du boîtier.

Selon un mode de réalisation, les premier et deuxième thyristors et les premier et deuxième dipôles sont disposés dans un même boîtier de protection comportant trois bornes de connexion extérieures connectées respectivement aux première et deuxième bornes de conduction et à la borne de commande du commutateur.

Selon un mode de réalisation, les premier et deuxième dipôles sont intégrés dans la ou les puces semiconductrices comprenant les premier et deuxième thyristors.

Selon un mode de réalisation, les premier et deuxième dipôles sont des composants discrets reportés sur la ou les puces semiconductrices comprenant les premier et deuxième thyristors.

Selon un mode de réalisation, les premier et deuxième thyristors sont disposés dans des puces semiconductrices distinctes.

Selon un mode de réalisation, les premier et deuxième thyristors sont intégrés dans une même puce semiconductrice et sont séparés par une région d'isolement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique d'un exemple d'un commutateur bidirectionnel de puissance ;
la figure 2 est une représentation schématique d'un autre exemple d'un commutateur bidirectionnel de puissance ;
la figure 3 est une représentation schématique d'un autre exemple d'un commutateur bidirectionnel de puissance ; et
la figure 4 est une représentation schématique d'un exemple d'un mode de réalisation d'un commutateur bidirectionnel de puissance.

### Description détaillée

De mêmes éléments ont été désignés par de mêmes références aux différentes figures. Dans la présente description, on utilisera le terme "connecté" pour désigner une liaison électrique directe, sans composant électronique intermédiaire, par exemple au moyen d'une ou plusieurs pistes conductrices ou d'un ou plusieurs fils conducteurs, et le terme "relié", pour désigner soit une liaison électrique directe (signifiant alors "connecté") soit une liaison via un ou plusieurs composants intermédiaires (résistance, condensateur, diode, etc.). Sauf précision contraire, les expressions "approximativement", "sensiblement", et "de l'ordre de" signifient à 20 % près, de préférence à 10 % près.

Dans la présente description, on entend par commutateur bidirectionnel de puissance un commutateur bidirectionnel en courant et en tension adapté à tenir des tensions relativement élevées à l'état ouvert, par exemple des tensions supérieures à 100 V et typiquement de l'ordre de 600 V ou plus.

On s'intéresse ici plus particulièrement aux commutateurs bidirectionnels de puissance du type comportant une association en antiparallèle de deux thyristors.

Dans un tel commutateur, l'un des thyristors est utilisé pour conduire des courants d'une première polarité, et l'autre thyristor est utilisé pour conduire des courants de polarité opposée. La fermeture d'un tel commutateur s'obtient en appliquant, sur une borne de commande du commutateur, un signal de commande apte à provoquer la mise en conduction du thyristor polarisé en direct. L'ouverture du commutateur s'effectue naturellement lorsque l'intensité du courant qui le traverse descend en dessous d'un seuil de conduction du thyristor actif (le thyristor préalablement mis en conduction), ou courant de maintien (IH) de ce thyristor.

Un problème qui se pose est que lors de l'ouverture d'un tel commutateur, par exemple à la fin d'une alternance du signal d'alimentation de la charge, il se produit un phénomène de recouvrement de charges entrainant l'inversion du courant circulant dans le thyristor actif. Normalement, ce courant inverse finit par s'annuler, et le commutateur reste bloqué jusqu'à la prochaine application d'un signal de déclenchement sur sa borne de commande. Toutefois, si l'intensité et la durée du courant inverse circulant dans le thyristor actif sont trop importantes, il existe un risque d'amorçage intempestif (non commandé) de l'autre thyristor (le thyristor inactif) en raison de transferts de porteurs qui peuvent se produire entre les deux thyristors. En pratique, la durée et l'amplitude du courant inverse circulant dans le thyristor actif lors de sa commutation de l'état passant vers l'état bloqué dépend de la pente de décroissance du courant circulant dans le commutateur et de la pente de croissance de la tension réappliquée aux bornes du commutateur lors de la commutation. Plus ces pentes sont élevées, plus le courant de recouvrement est important, et plus le risque d'amorçage intempestif du thyristor inactif est important.

Dans certaines applications, par exemple les applications de contrôle de moteur, il est important de pouvoir disposer de commutateurs bidirectionnels ayant de bonnes performances de commutation, c'est-à-dire capables de s'ouvrir sans risque de réamorçage intempestif lorsque les pentes de variation du signal de puissance vu par le commutateur sont importantes.

En pratique, pour respecter les contraintes de performances en commutation requises dans certaines applications, les concepteurs de circuits doivent prendre des précautions relativement contraignantes, pouvant notamment conduire à augmenter le prix de revient du dispositif. Par exemple, pour obtenir les performances en commutation souhaitées, les concepteurs de circuits sont souvent amenés à choisir des commutateurs surdimensionnés par rapport aux besoins effectifs de l'application en termes d'intensité de courant et d'amplitude de tension vues par le commutateur. En outre, ils peuvent être contraints de connecter aux bornes du commutateur un circuit de filtrage, par exemple un circuit RC, pour augmenter la robustesse du commutateur aux amorçages intempestifs.

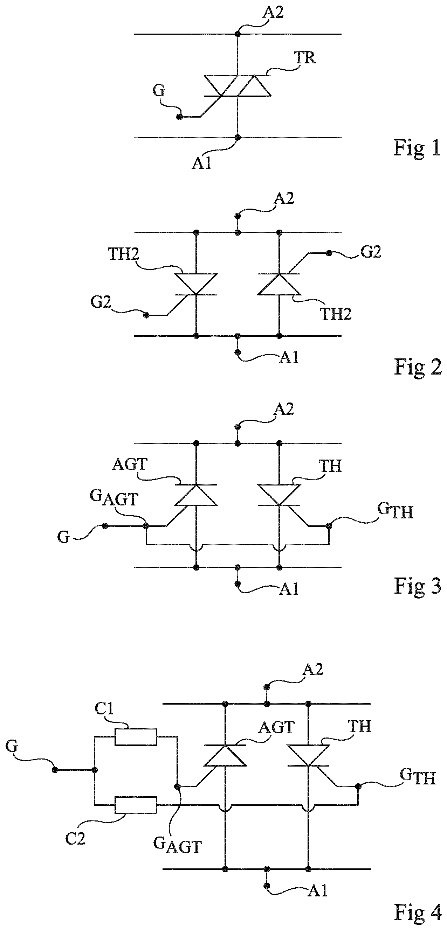

La figure 1 est une représentation schématique d'un triac TR. Les triacs sont parmi les commutateurs bidirectionnels de puissance les plus classiques. Un triac correspond à l'association en antiparallèle de deux thyristors (non visibles sur la figure). L'anode du premier thyristor et la cathode du deuxième thyristor sont connectées à une première borne principale ou borne de conduction A1 du triac. La cathode du premier thyristor et l'anode du deuxième thyristor sont connectées à une deuxième borne principale ou borne de conduction A2 du triac. La gâchette ou borne de commande G d'un triac classique correspond à la gâchette des deux thyristors qui le constituent. Les signaux de commande appliqués sur la gâchette G sont référencés par rapport à l'une des deux bornes de conduction A1 et A2.

Un triac classique est un composant monolithique, c'est-à-dire que les deux thyristors qui le constituent sont formés dans une même puce semiconductrice. Il n'est généralement pas prévu d'isolation entre les deux thyristors, qui peuvent partager de mêmes couches semiconductrices notamment au niveau de leurs parties actives. Des transferts de porteurs sont donc susceptibles de se produire entre les deux thyristors, ce qui limite les performances en commutation d'un tel composant.

La figure 2 est une représentation schématique d'un autre exemple d'un commutateur bidirectionnel de puissance. Le commutateur de la figure 2 comprend deux thyristors à gâchette de cathode TH1 et TH2 connectés en antiparallèle. Dans cet exemple, les thyristors TH1 et TH2 sont isolés l'un de l'autre, c'est-à-dire qu'ils sont formés dans des puces semiconductrices distinctes, ou qu'ils sont intégrés dans une même puce semiconductrice mais que leurs parties actives sont séparées par une région d'isolement. L'anode du thyristor TH1 et la cathode du thyristor TH2 sont connectées à une première borne principale ou borne de conduction A1 du commutateur. La cathode du thyristor TH1 et l'anode du thyristor TH2 sont connectées à une deuxième borne principale ou borne de conduction A2 du commutateur. Les gâchettes de cathode des thyristors TH1 et TH2 sont connectées à deux bornes de commande G1 et G2 isolées l'une de l'autre.

Si la tension entre les bornes A1 et A2 est positive, la fermeture du commutateur s'obtient en appliquant sur la borne de commande G2 un signal de commande référencé par rapport à la borne de conduction A2, apte à provoquer la mise en conduction du thyristor TH2. Si la tension entre les bornes A1 et A2 est négative, la fermeture du commutateur s'obtient en appliquant sur la borne de commande G1 un signal de commande référencé par rapport à la borne de conduction A1, apte à provoquer la mise en conduction du thyristor TH1.

Dans un tel commutateur, les thyristors TH1 et TH2 étant isolés l'un de l'autre, les risques de transferts de porteurs entre les deux thyristors et d'amorçage intempestif du thyristor inactif lors de l'ouverture du thyristor actif sont faibles. Un tel commutateur présente donc de bonnes performances en commutation. Toutefois, un inconvénient d'un tel commutateur est qu'il comprend deux bornes de commande isolées référencées par rapport à des bornes de conduction distinctes du commutateur. Ce commutateur nécessite donc un circuit de commande relativement complexe.

La figure 3 est une représentation schématique d'un autre exemple d'un commutateur bidirectionnel de puissance. Le commutateur de la figure 3 comprend un thyristor à gâchette de cathode TH et un thyristor à gâchette d'anode AGT connectés en antiparallèle. Comme dans l'exemple de la figure 2, les deux thyristors TH et AGT sont isolés l'un de l'autre, c'est-à-dire qu'ils sont formés dans des puces semiconductrices distinctes, ou qu'ils sont intégrés dans une même puce semiconductrice mais séparés l'un de l'autre par une région d'isolement. L'anode du thyristor AGT et la cathode du thyristor TH sont connectées à une première borne principale ou borne de conduction A1 du commutateur. La cathode du thyristor AGT et l'anode du thyristor TH sont connectées à une deuxième borne principale ou borne de conduction A2 du commutateur. La gâchette de cathode G_{TH} du thyristor TH et la gâchette d'anode G_{AGT} du thyristor AGT sont connectées à une même borne de commande G du commutateur.

La fermeture du commutateur s'obtient en appliquant sur la borne de commande G un signal de commande référencé par rapport à la borne de conduction A1, apte à provoquer la mise en conduction du thyristor AGT si la tension entre les bornes A1 et A2 est positive, et la mise en conduction du thyristor TH si la tension entre les bornes A1 et A2 est négative.

Par rapport au commutateur de la figure 2, le commutateur de la figure 3 présente l'avantage de comprendre une unique borne de commande G référencée par rapport à l'une seulement des bornes de conduction du commutateur, ce qui simplifie la mise en oeuvre de sa commande.

Par rapport au triac de la figure 1, le commutateur de la figure 3 a comme avantage que les parties actives de ses deux thyristors sont isolées l'une de l'autre, ce qui limite les risques d'amorçage parasite du thyristor inactif lors de l'ouverture du thyristor actif.

Des essais réalisés sur des commutateurs du type décrit en relation avec la figure 3 ont toutefois montré que les performances en commutation de ce type de commutateur restent relativement faibles, notamment par rapport à un commutateur du type décrit en relation avec la figure 2. Une explication possible réside dans le fait que les gâchettes G_{TH} et G_{AGT} des deux thyristors sont connectées, ce qui rend possible des transferts parasites de porteurs entre les deux thyristors. Une étude menée par la société demanderesse a notamment mis en exergue que lors de l'ouverture du thyristor AGT (à la fin d'une phase de circulation d'un courant de l'électrode A1 vers l'électrode A2 du commutateur), pendant la phase de recouvrement de charges dans le thyristor AGT, un courant relativement important, typiquement de l'ordre de quelques mA, transite du thyristor AGT vers le thyristor TH par l'intermédiaire des gâchettes G_{AGT} et G_{TH} des deux thyristors. En outre, lors de l'ouverture du thyristor TH (à la fin d'une phase de circulation d'un courant de l'électrode A1 vers l'électrode A2 du commutateur), pendant une phase de recouvrement de charges dans le thyristor TH, un courant (moins important) transite du thyristor TH vers le thyristor AGT par l'intermédiaire des gâchettes G_{TH} et G_{AGT}.

On prévoit un commutateur bidirectionnel de puissance comportant un thyristor à gâchette d'anode et un thyristor à gâchette de cathode connectés en antiparallèle, les gâchettes des deux thyristors étant reliées à une même borne de commande du commutateur et au moins une résistance ou au moins une diode séparant les gâchettes des deux thyristors.

La figure 4 est une représentation schématique d'un exemple d'un mode de réalisation d'un commutateur bidirectionnel de puissance. Le commutateur de la figure 4 comprend un thyristor à gâchette de cathode TH et un thyristor à gâchette d'anode AGT connectés en antiparallèle. Comme dans l'exemple de la figure 3, les thyristors TH et AGT sont isolés l'un de l'autre, c'est-à-dire qu'ils sont formés dans des puces semiconductrices distinctes, ou qu'ils sont intégrés dans une même puce semiconductrice mais séparés l'un de l'autre par une région d'isolement. L'anode du thyristor AGT et la cathode du thyristor TH sont connectées à une première borne principale ou borne de conduction A1 du commutateur. La cathode du thyristor AGT et l'anode du thyristor TH sont connectées à une deuxième borne principale ou borne de conduction A2 du commutateur.

Dans l'exemple de la figure 4, un élément C1 relie la gâchette d'anode G_{AGT} du thyristor AGT à une borne de commande G du commutateur, et un élément C2 relie la gâchette d'anode G_{TH} du thyristor TH à la borne G. L'élément C1 est un dipôle dont une première extrémité est connectée à la gâchette G_{AGT} du thyristor AGT et dont l'autre extrémité est connectée à la borne G, et l'élément C2 est un dipôle dont une première extrémité est connectée à la gâchette G_{TH} du thyristor TH et dont l'autre extrémité est connectée à la borne G. Selon un exemple utile pour comprendre la présente invention chacun des éléments C1 et C2 peut être une résistance, une diode, ou une simple piste conductrice (ou fil conducteur), par exemple en métal. Au moins l'un des éléments C1 et C2 est une résistance ou une diode, de sorte que la gâchette d'anode G_{AGT} du thyristor AGT et la gâchette de cathode G_{TH} du thyristor TH ne sont pas directement connectées l'une à l'autre. Dans le cas où l'élément C1 ou C2 est une résistance, la valeur de la résistance est choisie nettement supérieure à la résistance normale d'une piste conductrice ou d'un fil conducteur, par exemple supérieure ou égale à 10 ohms.

Plusieurs possibilités apparaîtront à l'homme du métier quant au choix des éléments C1 et C2 permettant d'obtenir l'effet recherché, à savoir la limitation ou la suppression des courants parasites circulant entre les deux thyristors par l'intermédiaire de leurs électrodes de gâchettes respectives, tout en conservant la possibilité de commander le commutateur par l'intermédiaire d'une unique borne de commande G référencée par rapport à l'une seulement de ses électrodes de conduction A1 et A2.

En préambule, on notera que les modes de réalisation décrits peuvent s'appliquer quels que soient les types d'amorçage et les structures des thyristors TH et AGT. En particulier, les thyristors TH et AGT peuvent être des thyristors de type à amorçage dans le quadrant Q1 ou Q2. Un thyristor à amorçage dans le quadrant Q1 est un thyristor qui peut être commandé à l'état passant par injection d'un courant positif sur sa gâchette lorsque sa tension anode-cathode est positive. Un thyristor à amorçage dans le quadrant Q2 est un thyristor pouvant être commandé à l'état passant par injection d'un courant négatif sur sa gâchette lorsque sa tension anode-cathode est positive. Dans la suite, on appellera respectivement TH_Q1, TH_Q2, AGT_Q1 et AGT_Q2 un thyristor à gâchette de cathode TH de type à amorçage dans le quadrant Q1, un thyristor à gâchette de cathode TH de type à amorçage dans le quadrant Q2, un thyristor à gâchette d'anode AGT de type à amorçage dans le quadrant Q1, et un thyristor à gâchette d'anode AGT de type à amorçage dans le quadrant Q2. De plus, pour des thyristors TH et AGT à structures verticales, quel que soit le type d'amorçage choisi, la structure du thyristor TH ou AGT peut être telle que la borne de conduction du thyristor à laquelle est référencée la gâchette (à savoir la cathode pour le thyristor TH et l'anode pour le thyristor AGT) soit sur la même face du thyristor que la borne de gâchette (structure verticale classique) ou soit sur la face du thyristor opposée à la gâchette (structure verticale dite de type ACS). Les modes de réalisation décrits ne se limitent toutefois pas à des thyristors TH et AGT à structure verticale, et peuvent notamment être mis en oeuvre en utilisant des thyristors TH et AGT à structure planaire. Plus généralement, les thyristors TH et AGT peuvent être réalisés dans toute technologie connue et selon tout agencement connu de réalisation de thyristors à gâchette de cathode et de thyristors à gâchette d'anode.

Le choix des éléments C1 et C2 sera fait en fonction du type des thyristors TH et AGT utilisés.

A titre d'exemple, les thyristors TH et AGT sont respectivement de type TH_Q2 et AGT_Q2, c'est-à-dire à amorçage en courant négatif. Dans ce cas, l'élément C1 est une diode dont l'anode est connectée à la gâchette G_{AGT} du thyristor AGT et dont la cathode est connectée à la borne G, et l'élément C2 est une diode dont l'anode est connectée à la gâchette G_{TH} du thyristor TH et dont la cathode est connectée à la borne G. Dans une telle configuration, le commutateur est amorcé par application d'un courant négatif sur sa borne G (référencée par rapport à la borne A1). Lors de la commutation à l'état ouvert, les diodes C1 et C2 bloquent les éventuels courants parasites susceptibles de circuler de la gâchette G_{AGT} du thyristor AGT vers la gâchette G_{TH} du thyristor TH, ou de la gâchette G_{TH} du thyristor TH vers la gâchette G_{AGT} du thyristor AGT.

A titre de variante, les thyristors TH et AGT sont respectivement de type TH_Q1 et AGT_Q1, c'est-à-dire à amorçage en courant positif. Dans ce cas, les éléments C1 et C2 sont des diodes connectées en direct respectivement entre la borne G et la gâchette G_{AGT} du thyristor AGT et entre la borne G et la gâchette G_{TH} du thyristor TH. Le commutateur peut alors être amorcé par application d'un courant positif sur sa borne G (référencée par rapport à la borne A1). Lors de la commutation à l'état ouvert, les diodes C1 et C2 bloquent les éventuels courants parasites susceptibles de circuler de la gâchette G_{AGT} du thyristor AGT vers la gâchette G_{TH} du thyristor TH, ou de la gâchette G_{TH} du thyristor TH vers la gâchette G_{AGT} du thyristor AGT.

Plus généralement, selon des exemples utiles pour comprendre l'invention, d'autres choix de combinaison et d'orientation des éléments C1 et C2 peuvent être réalisés en fonction des quadrants dans lesquels on souhaite pouvoir commander le commutateur.

A titre de variante, l'un et/ou l'autre des éléments C1 et C2 est une résistance de valeur comprise entre 10 et 200 ohms, ce qui permet non pas de bloquer mais de limiter significativement les transferts parasites de porteurs entre les deux thyristors par l'intermédiaire de leurs gâchettes G_{AGT} et G_{TH}.

A titre de variante, l'un et/ou l'autre des éléments C1 et C2 peut être une résistance connectée en série avec une diode.

Un avantage du mode de réalisation décrit en relation avec la figure 4 est qu'il permet, avec un coût relativement limité, d'améliorer significativement les performances en commutation d'un commutateur du type décrit en relation avec la figure 3. On notera en particulier que les éléments C1 et/ou C2 ajoutés par rapport au commutateur de la figure 3 sont relativement peu coûteux dans la mesure où il ne s'agit pas d'éléments destinés à supporter de fortes puissances, mais seulement à bloquer et/ou limiter les courants parasites circulant entre les gâchettes des deux thyristors.

A titre d'exemple, les thyristors AGT et TH peuvent être deux puces semiconductrices distinctes assemblées dans un même boîtier de protection comportant quatre bornes de connexion extérieures connectées respectivement aux bornes A1, A2, G_{AGT} et G_{TH}. Cette configuration laisse la possibilité au concepteur du circuit applicatif de choisir lui-même les éléments C1 et C2 à ajouter, en fonction des contraintes de l'application.

Les modes de réalisation décrits ne se limitent toutefois pas à ce cas particulier. A titre de variante, les éléments C1 et/ou C2 sont disposés dans le même boîtier de protection que les thyristors TH et AGT, ce boîtier pouvant alors ne comporter que trois bornes de connexion extérieures connectées respectivement aux bornes A1, A2 et G du commutateur.

A titre de variante, les thyristors TH et AGT sont intégrés dans une même puce semiconductrice et séparés par une région d'isolement. Les éléments C1 et/ou C2 peuvent alors soit être des composants discrets soit être intégrés dans la puce comportant les thyristors TH et AGT.

## Revendications

1. Commutateur bidirectionnel de puissance comportant des premier (AGT) et second (TH) thyristors isolés l'un de l'autre et connectés en antiparallèle entre des première (A1) et deuxième (A2) bornes de conduction du commutateur, le premier thyristor (AGT) étant un thyristor à gâchette d'anode, le second thyristor (TH) étant un thyristor à gâchette de cathode, et les gâchettes (G_{AGT}, G_{TH}) des premier (AGT) et second (TH) thyristors étant reliées à une même borne de commande (G) du commutateur,
dans lequel un premier dipôle (C1) relie la gâchette du premier thyristor (AGT) à la borne de commande (G) et un deuxième dipôle (C2) relie la gâchette du deuxième thyristor (TH) à la borne de commande (G),
**caractérisé en ce que** :
a) le premier dipôle (C1) est une diode dont l'anode est connectée à la gâchette (G_{AGT}) du premier thyristor (AGT) et dont la cathode est connectée à la borne de commande (G), et dans lequel le deuxième dipôle (C2) est une diode dont l'anode est connectée à la gâchette (G_{TH}) du deuxième thyristor (TH) et dont la cathode est connectée à la borne de commande (G) ; ou
b) le premier dipôle (C1) est une diode dont la cathode est connectée à la gâchette (G_{AGT}) du premier thyristor (AGT) et dont l'anode est connectée à la borne de commande (G), et dans lequel le deuxième dipôle (C2) est une diode dont la cathode est connectée à la gâchette (G_{TH}) du deuxième thyristor (TH) et dont l'anode est connectée à la borne de commande (G) ; ou
c) au moins l'un des premier (C1) et deuxième (C2) dipôles comprend une résistance de valeur comprise entre 10 et 200 ohms.

2. Commutateur selon l'alternative a) de la revendication 1, dans lequel les premier (AGT) et second (TH) thyristors sont de type à amorçage dans le quadrant Q2.

3. Commutateur selon l'alternative b) de la revendication 1, dans lequel les premier (AGT) et second (TH) thyristors sont de type à amorçage dans le quadrant Q1.

4. Commutateur selon l'une quelconque des revendications 1 à 3, dans lequel les premier (AGT) et deuxième (TH) thyristors sont disposés dans un même boîtier de protection comportant quatre bornes de connexion extérieures connectées respectivement aux première (A1) et deuxième (A2) bornes de conduction du commutateur, à la gâchette d'anode (G_{AGT}) du premier thyristor (AGT), et à la gâchette de cathode (G_{TH}) du deuxième thyristor (TH), et dans lequel les premier (C1) et deuxième (C2) dipôles sont disposés à l'extérieur du boîtier.

5. Commutateur selon l'une quelconque des revendications 1 à 3, dans lequel les premier (AGT) et deuxième (TH) thyristors et les premier (C1) et deuxième (C2) dipôles sont disposés dans un même boîtier de protection comportant trois bornes de connexion extérieures connectées respectivement aux première (A1) et deuxième (A2) bornes de conduction et à la borne de commande (G) du commutateur.

6. Commutateur selon la revendication 5, dans lequel les premier (C1) et deuxième (C2) dipôles sont intégrés dans la ou les puces semiconductrices comprenant les premier (AGT) et deuxième (TH) thyristors.

7. Commutateur selon la revendication 5, dans lequel les premier (C1) et deuxième (C2) dipôles sont des composants discrets reportés sur la ou les puces semiconductrices comprenant les premier (AGT) et deuxième (TH) thyristors.

8. Commutateur selon l'une quelconque des revendications 1 à 7, dans lequel les premier (AGT) et deuxième (TH) thyristors sont disposés dans des puces semiconductrices distinctes.

9. Commutateur selon l'une quelconque des revendications 1 à 7, dans lequel les premier (AGT) et deuxième (TH) thyristors sont intégrés dans une même puce semiconductrice et sont séparés par une région d'isolement.

## Patentansprüche

1. Bidirektionaler Leistungsschalter mit einem ersten (AGT) und einem zweiten (TH) Thyristor, die voneinander isoliert und antiparallel zwischen einen ersten (A1) und einen zweiten (A2) Leitungsanschluss des Schalters geschaltet sind, wobei der erste Thyristor (AGT) ein Anoden-Gate-Thyristor ist, der zweite Thyristor (TH) ein Kathoden-Gate-Thyristor ist und die Gates (G_{AGT}, G_{TH}) des ersten (AGT) und des zweiten (TH) Thyristors mit demselben Steueranschluss (G) des Schalters gekoppelt sind,
wobei ein erster Dipol (C1) das Gate des ersten Thyristors (AGT) mit dem Steueranschluss (G) koppelt und ein zweiter Dipol (C2) das Gate des zweiten Thyristors (TH) mit dem Steueranschluss (G) koppelt,
**dadurch gekennzeichnet, dass**:
a) der erste Dipol (C1) eine Diode ist, deren Anode mit dem Gate (G_{AGT}) des ersten Thyristors (AGT) verbunden ist und deren Kathode mit dem Steueranschluss (G) verbunden ist, und wobei der zweite Dipol (C2) eine Diode ist, deren Anode mit dem Gate (G_{TH}) des zweiten Thyristors (TH) verbunden ist und deren Kathode mit dem Steueranschluss (G) verbunden ist; oder
b) der erste Dipol (C1) eine Diode ist, deren Kathode mit dem Gate (G_{AGT}) des ersten Thyristors (AGT) verbunden ist und deren Anode mit dem Steueranschluss (G) verbunden ist, und wobei der zweite Dipol (C2) eine Diode ist, deren Kathode mit dem Gate (G_{TH}) des zweiten Thyristors (TH) verbunden ist und deren Anode mit dem Steueranschluss (G) verbunden ist; oder
c) mindestens einer der ersten (C1) und zweiten (C2) Dipole einen Widerstand mit einem Wert im Bereich von 10 bis 200 Ohm aufweist.

2. Schalter nach Alternative a) zu Anspruch 1, wobei der erste (AGT) und der zweite (TH) Thyristor von dem Typ sind, der im Quadranten Q2 einschaltet.

3. Schalter nach Alternative b) zu Anspruch 1, wobei der erste (AGT) und der zweite (TH) Thyristor von dem Typ sind, der im Quadranten Q1 einschaltet.

4. Schalter nach einem der Ansprüche 1 bis 3, wobei der erste (AGT) und der zweite (TH) Thyristor in einem gleichen Schutzgehäuse angeordnet sind, das vier externe Verbindungsanschlüsse aufweist, die jeweils mit dem ersten (A1) und dem zweiten (A2) Leitungsanschluss des Schalters, mit dem Anodengate (G_{AGT}) des ersten Thyristors (AGT) und mit dem Kathodengate (G_{TH}) des zweiten Thyristors (TH) verbunden sind, und wobei der erste (C1) und der zweite (C2) Dipol außerhalb des Gehäuses angeordnet sind.

5. Schalter nach einem der Ansprüche 1 bis 3, wobei der erste (AGT) und der zweite (TH) Thyristor und der erste (C1) und der zweite (C2) Dipol in einem gleichen Schutzgehäuse angeordnet sind, das drei externe Verbindungsanschlüsse aufweist, die jeweils mit dem ersten (A1) und dem zweiten (A2) Leitungsanschluss des Schalters und mit dem Steueranschluss (G) des Schalters verbunden sind.

6. Schalter nach Anspruch 5, wobei der erste (C1) und der zweite (C2) Dipol in den/die Halbleiterchip(s) integriert sind, der/die den ersten (AGT) und den zweiten (TH) Thyristor aufweist/aufweisen.

7. Schalter nach Anspruch 5, wobei der erste (C1) und der zweite (C2) Dipol diskrete Komponenten sind, die auf dem/den Halbleiterchip(s) mit dem ersten (AGT) und dem zweiten (TH) Thyristor angeordnet sind.

8. Schalter nach einem der Ansprüche 1 bis 7, wobei der erste (AGT) und der zweite (TH) Thyristor in unterschiedlichen Halbleiterchips angeordnet sind.

9. Schalter nach einem der Ansprüche 1 bis 7, bei dem der erste (AGT) und der zweite (TH) Thyristor in einem gleichen Halbleiterchip integriert und durch einen isolierenden Bereich getrennt sind.

## Claims

1. A bidirectional power switch comprising first (AGT) and second (TH) thyristors insulated from each other and connected in antiparallel between first (A1) and second (A2) conduction terminals of the switch, the first thyristor (AGT) being an anode-gate thyristor, the second thyristor (TH) being a cathode gate thyristor, and the gates (G_{AGT}, G_{TH}) of the first (AGT) and second (TH) thyristors being coupled to a same control terminal (G) of the switch,
wherein a first dipole (C1) couples the gate of the first thyristor (AGT) to the control terminal (G) and a second dipole (C2) couples the gate of the second thyristor (TH) to the control terminal (G),
**characterized in that**:
a) the first dipole (C1) is a diode having its anode connected to the gate (G_{AGT}) of the first thyristor (AGT) and having its cathode connected to the control terminal (G), and wherein the second dipole (C2) is a diode having its anode connected to the gate (G_{TH}) of the second thyristor (TH) and having its cathode connected to the control terminal (G); or
b) the first dipole (C1) is a diode having its cathode connected to the gate (G_{AGT}) of the first thyristor (AGT) and having its anode connected to the control terminal (G), and wherein the second dipole (C2) is a diode having its cathode connected to the gate (G_{TH}) of the second thyristor (TH) and having its anode connected to the control terminal (G); or
c) at least one of the first (C1) and second (C2) dipoles comprises a resistor having a value in the range from 10 to 200 ohms.

2. The switch according to alternative a) of claim 1, wherein the first (AGT) and second (TH) thyristors are of the type turning on in quadrant Q2.

3. The switch according to alternative b) of claim 1, wherein the first (AGT) and second (TH) thyristors are of the type turning on in quadrant Q1.

4. The switch according to any of claims 1 to 3, wherein the first (AGT) and second (TH) thyristors are arranged in a same protection package comprising four external connection terminals respectively connected to the first (A1) and second (A2) conduction terminals of the switch, to the anode gate (G_{AGT}) of the first thyristor (AGT), and to the cathode gate (G_{TH}) of the second thyristor (TH), and wherein the first (C1) and second (C2) dipoles are arranged outside of the package.

5. The switch according to any of claims 1 to 3, wherein the first (AGT) and second (TH) thyristors and the first (C1) and second (C2) dipoles are arranged in a same protection package comprising three external connection terminals respectively connected to the first (A1) and second (A2) conduction terminals of the switch and to the control terminal (G) of the switch.

6. The switch according to claim 5, wherein the first (C1) and second (C2) dipoles are integrated in the semiconductor chip(s) comprising the first (AGT) and second (TH) thyristors.

7. The switch according to claim 5, wherein the first (C1) and second (C2) dipoles are discrete components placed on the semiconductor chip(s) comprising the first (AGT) and second (TH) thyristors.

8. The switch according to any of claims 1 to 7, wherein the first (AGT) and second (TH) thyristors are arranged in different semiconductor chips.

9. The switch according to any of claims 1 to 7, wherein the first (AGT) and second (TH) thyristors are integrated in a same semiconductor chip and separated by an insulating region.
